Europäisches Patentamt

European Patent Office

Office européen des brevets

(19)

(11) **EP 1 120 913 A1**

(12) **EUROPEAN PATENT APPLICATION**

(43) Date of publication:
**01.08.2001 Bulletin 2001/31**

(51) Int Cl.[7]: **H03K 5/13**, H03L 7/081

(21) Application number: **01201022.9**

(22) Date of filing: **31.01.1994**

| | |
|---|---|
| (84) Designated Contracting States:<br>**AT BE CH DE DK ES FR GB GR IE IT LI LU MC NL<br>PT SE**<br><br>(30) Priority: **05.02.1993 US 14121**<br><br>(62) Document number(s) of the earlier application(s) in<br>accordance with Art. 76 EPC:<br>**94300709.6 / 0 610 052**<br><br>(71) Applicant: **SUN MICROSYSTEMS, INC.**<br>**Palo Alto, California 94303 (US)** | (72) Inventor: **Bassett, Paul D.**<br>**Boxboro, Massachusetts 01719 (US)**<br><br>(74) Representative: **Harris, Ian Richard et al**<br>**D. Young & Co.,**<br>**21 New Fetter Lane**<br>**London EC4A 1DA (GB)**<br><br>Remarks:<br>This application was filed on 19 - 03 - 2001 as a<br>divisional application to the application mentioned<br>under INID code 62. |

(54) **Method and apparatus for timing control**

(57) A timing control apparatus synchronizes the operation of logic devices to an external reference clock signal. In one aspect, the apparatus includes an oscillator (14) that generates an internal reference clock signal (16) and a phase comparator (20) that generates an error signal (20c) indicating the difference in phase and frequency between the internal (16) and external (18) clock signals. A filter (12) coupled to the comparator (20) generates plural control signals (13a,13b), each having a characteristic, e.g. a voltage amplitude, that is a selected function of the error signal (20c). The control signals (13a,13b) are routed to the oscillator (14), which generates the internal reference clock signal (16) as a function of those control signals (13a,13b).

FIG. 1

**Description**

The present invention relates the coordination of timing of electronic sequential logic systems. More particularly, it relates to apparatus and methods for synchronizing the sequential operation of multiple electronic circuits to an external reference clock.

Computers and other digital systems are constructed from discrete logic devices, such as processing, memory, and interface devices. Overall operation of these systems depends on synchronous operation of the underlying logic devices. Typically, synchronism is attained by driving a common clock signal to the devices and strobing their respective input, output and processing operations based on that signal. In high-speed systems, e.g., supercomputers, extraordinary demands are placed on the circuitry provided with each individual logic device to synchronize its responses to the reference clock signal.

One particular problem is that of "clock skew," which results from differences in the propagation delays of buffer circuits within the logic devices. As those skilled in the art will appreciate, buffers are provided to reduce the capacitive load on the common, or external, reference clock signal. Clock signals applied to each device are delayed as they pass through the respective buffers. The length of the delay varies based on the specific characteristics of each buffer. Because those characteristics and the resulting delays tend to vary, it has generally proven difficult to ensure synchronous operation of complex, high-speed systems.

The art has proposed various timing control systems to compensate for propagation delay-induced clock skew. One such solution provides, within each discrete logic device, a phase lock loop that "locks" onto the external reference clock signal and generates an internal clock signal that is coordinated, in phase and frequency, to the external clock. Each device operates from its respective internal clock signal instead of the external clock, from which it is capacitively decoupled and, yet, coordinated in frequency and phase.

Although this solution is adequate for some systems, it is generally not suitable for digital processing systems that operate at more than one processing speed or in a noisy environments. In such circumstances, because a conventional phase lock loop is constrained by a limited "capture" range, it may not be able to lock onto the external clock and, therefore, will not be able to generate a synchronous internal clock signal.

In addition to clock skew, further timing control problems often arise when there are transient variations in power supply voltage levels. In this regard, it will be appreciate that the processing speed of many individual logic devices decreases as power supply voltage levels fall. Because these changes vary from device to device, momentary dips in power level (which dips can occur even in the normal course, e.g., when multiple devices simultaneously draw increased power) can disrupt the synchronous operation of multiple devices.

A further problem in timing control is the synchronization of signals (e.g., data) output by multiple logic devices. As above, the coordination of output signals depends on propagation delays of the circuitry used by those devices to buffer outgoing signals. Differences can result in signal skew between otherwise synchronous data output by the devices. This, in turn, can slow overall processing speed, as the system compensates by holding otherwise inactive data output by the faster devices.

In view of the foregoing, an object of the present invention is to provide an improved timing control system and, more particularly, an improved system for coordinating the synchronous operation of discrete logic devices.

Various embodiments of the invention may variously provide an improved timing control apparatus that operates over a wide range of processing speeds to coordinate the synchronous operation of multiple logic device to a common external reference signal, and/or

provide a system for coordinating the operation of logic devices in environments where the power supply voltage varies, and/or

provide a system for coordinating the output signals transmitted by logic devices.

Other general and specific features of the invention will be evident in the description which follows, which invention, in its various aspects, is as claimed in the claims.

The invention provides, in one aspect, a timing control apparatus operable over a range of frequencies for synchronizing the operation of logic devices to an external reference clock signal.

The apparatus includes an oscillator that generates an internal reference clock signal, as well as a phase comparator that generates an error signal indicating the difference in phase and frequency between the internal and external clock signals. A filter coupled to the comparator generates plural control signals, each having a characteristic, e.g., a voltage amplitude, that is a selected function of the error signal. The control signals are routed to the oscillator, which generates the internal reference clock signal as a function of those control signals.

In a related aspect of the invention, the filter generates the respective control signals based on selected frequency spectra of the error signal. Thus, the filter can be a third- order low-pass filter that generates one control signal as a function of a first portion of frequency spectrum, e.g., the fundamental frequency of possible external reference clocks, and that generates another control signal as a function of a second portion of the frequency spectrum, e.g., the probable frequency bands of system noise.

The oscillator, according to another related aspect of the invention, can include a summing network that generates the internal reference clock signal with a frequency and phase related to a weighted sum of the plural control signals.

According to a further aspect, the invention provides a timing control apparatus that generates a clock signal having a frequency that increases in response to decreases in power supply voltage levels. The apparatus includes an oscillator switch coupled to the system power supply and to a current source, which generates a reference current independent of the power supply voltage. The switch oscillates with a frequency that is a function of a ratio of the reference current relative to the power supply voltage level. Thus, as the power supply voltage decreases, the oscillation frequency increases.

In a related aspect of the invention, the switch comprises a plurality of CMOS inverter gates connected in series and configured as a ring oscillator. As the power supply voltage levels decrease, the propagation delay of the ring decreases, thereby increasing the frequency of the generated clock signal.

In still another aspect, the invention provides a timing control apparatus for generating a plurality of time-delayed signals coordinated to an input signal, e.g., an external clock signal. The apparatus includes an oscillator that generates, e.g., an internal clock reference signal, and a delay element that generates time-delayed signals offset from that internal clock signal. A comparator compares the internal and external clock signals to generate an error signal that indicates the phase and frequency difference therebetween. A filter, coupled to the comparator, generates plural control signals each having a characteristic, e.g., a voltage amplitude, that is a selected function of the error signal. Those control signals are fed to the oscillator which, in turn, feeds its output to the delay element. The delay element, which can employ a ring of CMOS inverter gates of the type described above, generates the time-delayed signals, each with a frequency substantially equal to that of the output signal and with a selected time-delay with respect thereto.

Another aspect provides a timing control apparatus of the type described above further including circuitry for delaying the generation of output signals (e.g., data) transmitted by the associated logical device's output buffer. In this regard, the apparatus can include a device-dependent delay element, coupled to the oscillator, for generating an output-effecting strobe signal that has a frequency substantially equal to the internal clock signal but that is time-delayed in accord with a characteristic delay of the output buffer.

Embodiments of these and other aspects of the present invention will now be described, by way of example only, with reference to the accompanying drawings, of which:

FIGURE 1 is a schematic representation of a preferred timing control apparatus according to the invention for generating an internal clock signal coordinated to an external reference clock signal.

FIGURE 2 is a detailed schematic representation of the device of FIGURE 1.

FIGURE 3 is a detailed schematic representation of a preferred voltage controlled oscillator used in the apparatus of **FIGURE 1.**

FIGURE 4 is a schematic representation of a preferred timing control apparatus according to the invention that generates a clock signal having a frequency that increases in response to decreases in power supply voltage levels.

**FIGURE 5** is a detailed schematic representation of the device of FIGURE 4.

**FIGURE 6** is a schematic representation of a preferred timing control apparatus as shown in Figure 1 including circuitry for generating time-delayed signals coordinated to an input signal.

FIGURE 7 is a detailed schematic representation of the delay circuit of FIGURE 6.

FIGURE 8 is a schematic representation of preferred timing control apparatus according to the invention including a device-dependent delay feature, e. g., for synchronizing the generation of output signals.

FIGURE 9 is a detailed schematic representation of a preferred process dependent delay 300 of Figure 8.

Figure 10 illustrates a sequential phase detector for use with comparator 20 (Figure 1) of a preferred timing control apparatus according to the invention.

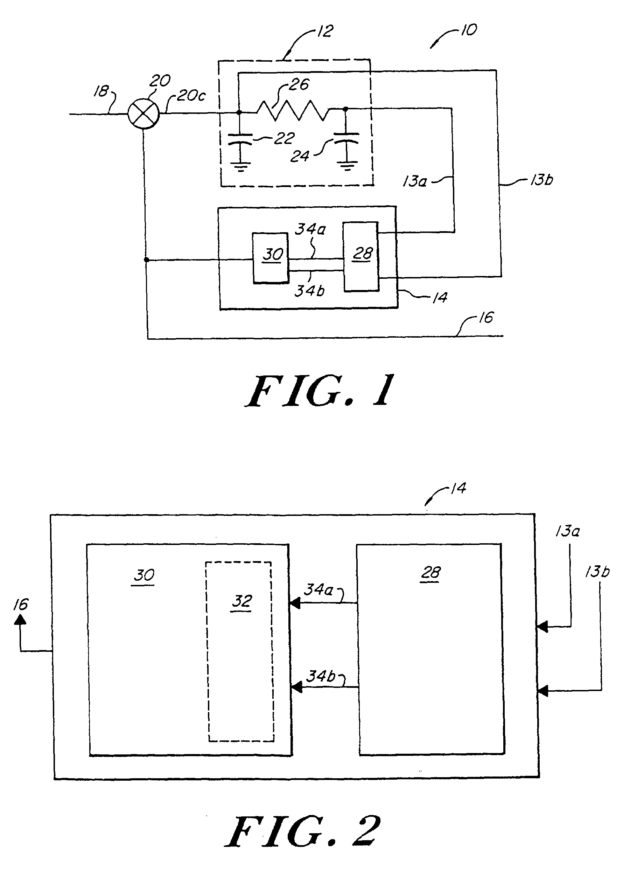

Figure 1 depicts a preferred timing control apparatus 10 constructed according to the invention for synchronizing the operation of an associated logic device, e.g., an integrated circuit chip or board (not shown), to an external clock signal 18. The apparatus 10 is generally configured as a feedback system and, more particularly, as a phase locked loop (PLL) with a filter 12 that generates multiple control signals 13a, 13b for controlling generation of an internal reference clock signal 16 by a voltage controlled oscillator (VCO) 14.

Referring to the drawing, the apparatus 10 includes a comparator 20 that generates an error signal 20c representing the difference in phase and frequency between the internal reference clock signal 16 and the external clock signal 18. The filter 12 is coupled to the comparator 20 to generate the control signals 13a, 13b, each having a voltage amplitude that is a function of the error signal 20c. Those control signals, which are preferably generated based on characteristics of respective selected frequency spectra of the error signal, are routed to VCO 14 for adjustment of the internal reference clock signal 16 as described below.

The external reference clock signal 18 can be, for example, a computer system clock or other control signal intended for synchronizing the operation of a sequential logic system. The external reference clock used in connection with a preferred embodiment of the invention operates in the range of 20 to 50 MHz and, preferably, 40 MHz. The internal reference clock signal 16 can, for example, serve as an internal clock signal for controlling operation of the associated logic device.

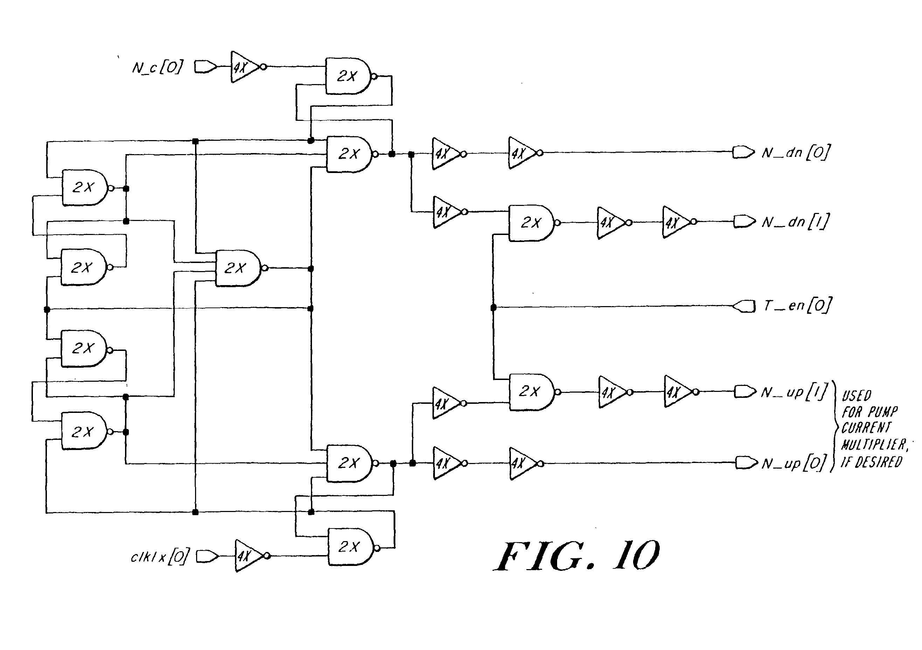

The comparator 20 can be constructed and operated in accord with conventional phase comparator structures, for example, an analog multiplier circuit or a digital EXCLUSIVE OR gate. A preferred such structure is a sequential phase detector (commonly referred to as a "phase-frequency detector"), of the type well known in the art. A preferred such structure is shown in Figure 10.

The filter 12 is a multiple response filter having subelements that generate respective unique control signals 13a, 13b in response to the error signal 20c. Preferably, those subelements generate those respective signals in response to selected respective portions of the frequency spectrum of the error signal 20c. The preferred, illustrated filter 12 is a third order low-pass filter comprising large capacitor 22, small capacitor 24 and resistor 26, arranged as shown.

As illustrated, control signal 13b is generated at the anode of the capacitor 22, while control signal 13a is generated at the anode of the capacitor 24. It will be appreciated that, in accord with the illustrated structure, control signals 13a, 13b are generated in response to substantially different frequency bands of the error signal. These different frequency bands can be selected by selecting or adjusting the values of the capacitors 22 and 24 and resistor 26 in accord with the teachings herein.

By way of example, in a preferred embodiment for use in synchronizing an external reference clock (as above, operating in the range of 20 to 50 MHz and, preferably, 40 MHz), capacitor 22 has a value of 2.5 pF, capacitor 24 has a value of 25 pF and resistor 26 has a value of 1k Ohms. In that embodiment, control signal 13a has a frequency band of 0 - 10 MHz, while control signal 13b has a frequency band of 0 - 16 MHz.

It will be appreciated that, in lieu of the illustrated structure, filter 12 can include a plurality of separate filter circuits each with a unique transfer function.

The oscillator 14 is a voltage-controlled oscillator that has plural control inputs as illustrated. The oscillator 14 includes an interface 28 that responds to the control signals 13a, 13b to generate frequency control signal 34a, 34b that toggle switch 30. More particularly, the interface 28 is configured to adjust the frequency of the switch 30 to reduce the difference between the frequency and the phase of the external clock signal 18 and the internal clock signal 16 in the manner described below. As illustrated, the signal 16 generated at the output of oscillator 14 is routed to comparator 20, as well as to the associated logic device for use in the timing and control thereof.

Figure 2 illustrates a preferred structure of voltage controlled oscillator 14. The voltage controlled oscillator 14 includes interface 28 configured as a voltage-controlled current source coupling control signals 13a, 13b, to the switch circuit 30. The switch circuit 30 can include a weighted sum network 32, connected to the voltage-controlled current source 28, that weights each frequency control signal 34a, 34b so that each has a selected effect on the rate at which the circuit switch 30 toggles and, consequently, on the frequency of the internal reference clock signal 16.

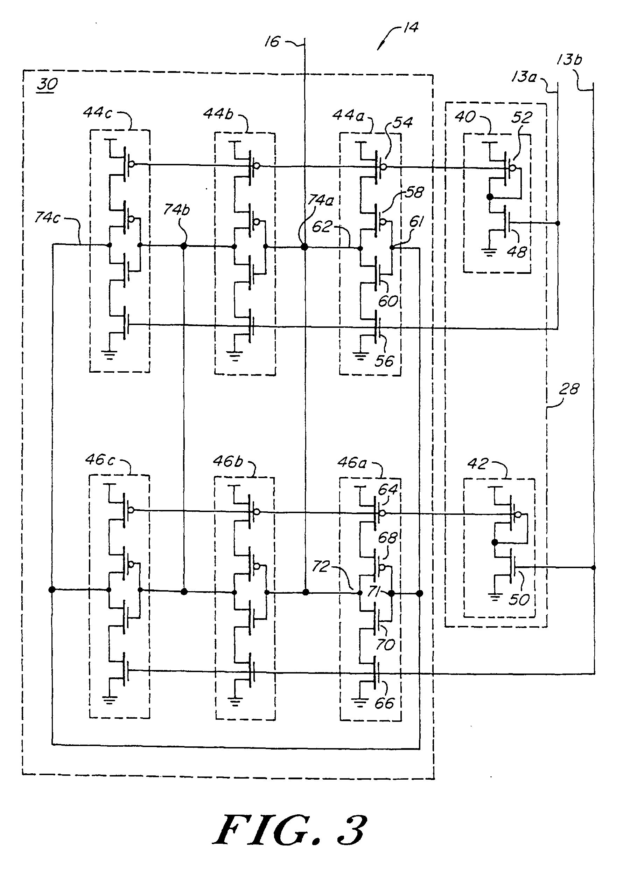

Figure 3 illustrates in still greater detail the structure of the voltage controlled oscillator 14. There it is seen that interface 28 consists of two voltage-controlled current sources, 40, 42, each responsive to a respective control signal 13a, 13b. The switch circuit 30, in turn, includes three pairs of ring oscillators stages, 44a/46a, 44b/46b, and 44c/46c.

More particularly, as shown in the drawing, the switch is constructed from three identical stages which are, in turn, constructed from identically configured sub-stages wired in parallel. Each sub-stage is connected to one of the current sources 40, 42 and is therefore responsive to one of the control signals 13a, 13b. In the example shown, substages 44a, 44b and 44c are connected to the current source 40 and are responsive to control signal 13a, while substages 46a, 46b and 46c are connected to current source 42 and are responsive to control signal 13b. It will be appreciated that further current sources and substages of the type illustrated could be added to the switch 30 to accommodate additional control signals generated by filter 12. It will also be appreciated that while switch 30 is shown to include three stages, the oscillator could be constructed from any odd number of stages (though, not necessarily from a single stage).

Illustrated current sources 40 and 42 each have an NMOS device with its gate connected to a corresponding input terminal of the oscillator 14, and with its source connected to the source of a matched PMOS device configured in saturation mode. In the illustrated embodiment, more particularly, exemplary current source 40 has an NMOS device 48 with a gate connected to an input terminal coupled to control signal 13a, while the current source 42 has an NMOS device 50 connected to terminal coupled to control signal 13b.

The structure and operation of current sources 40, 42 will now be described with reference to exemplary current source 40.

Control signal 13a from filter 12 is routed to the gate of the NMOS device 48 to regulate the current through both it (the NMOS device 48) and the associated PMOS device 52. In operation, the control signal 13a places a voltage bias across the gate-to-source junction of the NMOS device 48 and draws a proportional reference current through both the NMOS device 48 and PMOS device 52. The reference current drawn through the PMOS device 52 causes a voltage drop occurs across the gate-to-drain junction of the PMOS device 52 identical to the voltage drop across the gate-to-drain junction of the NMOS device 48. In this way, the current source 40 produces two control voltages at the gates of MOS devices 48, 52 proportional to the reference current drawn through those devices 48, 52 and, therefore, proportional to the control signal 13a.

The ring oscillator 44 couples to both MOS devices 48, 52 as illustrated.

As further illustrated, the gate of the PMOS device 52 connects to the gate of the PMOS device 54, each, while the gate of the NMOS device 48 connects to the gate of the NMOS device 56. This structure causes the devices 54 and 56 to act as current mirrors to the current source 40. Accordingly, current driven through the inverter circuit 44 is proportional to the control signal 13a received at input terminal 14a.

With continued reference to Figure 3, a second pair of MOS devices, 58 and 60 form a CMOS inverter gate that switches between current mirrors 54 and 56 to drive the output 62. The load on each delay stage within the circuit 30 is equal to the load presented by the next pair of substages and is fixed. With this structure, and the fixed output load, the output voltage at 62 switches at a speed that is dependent on the current driven by the current mirrors 54 and 56. Therefore, the rate at which the ring oscillator 44a toggles is controlled by the voltage level of the control signal 13a.

The outputs of ring oscillators 44a, 46a are wired together to form the outputs of the switch circuit 30. Illustrated output 74a is a summing node that sums the output currents of ring oscillators 44a and 46a, as shown. Similarly, the outputs of sub-stages 44b, 46b are connected to form 74b, while the outputs of sub-stages 44c and 46c are connected to form 74c. The output 74c is fed-back to the inputs 61 and 71 of each sub-stage 44a and 46a, as shown. As a result of this feedback structure, the switch circuit 30 forms an oscillator. The rate at which the switch circuit 30 oscillates depends on the rate at which each of the stages toggles and this, in turn, depends on the currents driven by the current mirrors within the sub-stage circuits.

The optional weighting network 32, referred to above (in connection with the discussion of Figure 2), is implemented by constructing the ring oscillators 44a and 46a with MOS devices of different sizes. Specifically, those devices are selected to produce a desired mirror current for a specific bias voltage at the gate of the current mirror devices 44, 56, 64 and 66.

In one preferred embodiment, the n-type MOS devices of the ring sub-stage 44a are 35 microns wide and the n-type MOS device of sub-stage 46a are 20 microns wide. This relative sizing causes the switch circuit 30 to weight the control signal 13a 7/4 (seven-fourths) times as much as the control signal 13b. The sum total of the output current at output 71 is therefore four times the current generated by the current source, 42, connected to control signal 13b and seven times the current generated by the current source, 40, connected to control signal 13a

It will be appreciated that the structures described above enable the oscillator 14 to be more responsive to those portions of the frequency spectrum of the error signal 20c that are most instrumental in synchronizing the frequency and phase of the reference clocks. Thus, high frequency noise components of the error signal 20c are transmitted from the low pass filter 12 as one control signal. The oscillator summing network 32 assigns a minimal weight to this control signal. Accordingly, small variations in the phase of the external clock signal 18 due to noise have less effect on the final generated internal reference clock 16 than does the fundamental frequency component of the external reference clock signal 18. As a result, the generated reference clock signal 16 is less affected by noise-induced transient frequency variations.

In sum, the timing control device 10, described above, synchronizes an internal reference clock signal 16 to an external reference clock 18. The device uses selected portions of the frequency spectrum of the error signal to control the generation of the internal reference clock 16. This enables the oscillator 14 to have a high voltage-to-frequency gain for certain frequency bands (and, therefore, to have a fast transient response within these bands) and, yet, still have a stable response to a broad range of frequencies. It will be appreciated that this new structure is both highly responsive and highly stable.

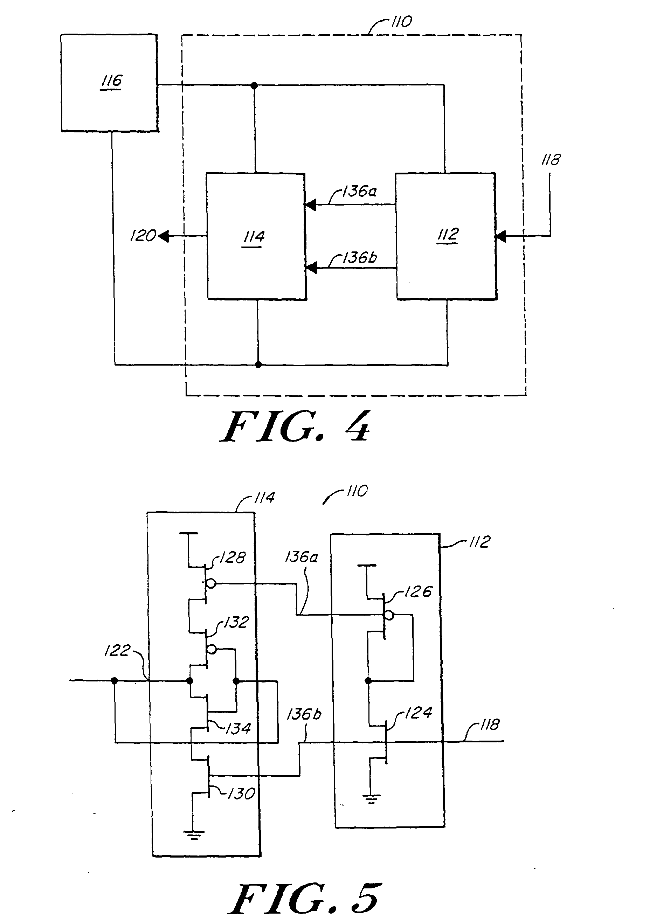

Figure 4 depicts a further aspect of the invention providing a timing control apparatus 110 that generates a clock signal 120 having a frequency that increases in response to decreases in power supply voltage levels. The apparatus includes an oscillator switch 114 that is coupled to the system power supply 116 and to a current source 112. Power supply 116 can be of structure and operation for supplying power to sequential logic systems. Current source 112 is a voltage-controlled current reference with a control input 118 that receives a voltage level and selectively controls the reference current generated by the current source 112. Preferably, current source 112 is has a structure identical to the current sources 40 and 42 shown in Figure 4 and described earlier.

The switch circuit 114 is a voltage-controlled switch that toggles at a rate responsive to control voltages 136a, 136b, as illustrated. The switch circuit generates a clock signal 120 of the type commonly used as a processor clock for synchronous logic systems. The switch 114 oscillates with a frequency that is a function of a ratio of the reference current relative to the power supply voltage level and, thus, given the constant reference current source, as the power supply voltage decreases, the oscillation frequency increases.

Figure 5 depicts in greater detail the construction of the oscillator 110. As illustrated there, the switch 114 preferably comprises a plurality of CMOS inverter gates connected in series and configured as a ring oscillator. As the power supply voltage levels decrease, the propagation delay of a signal passing through the ring decreases, thereby increasing the frequency of the generated clock signal 120.

Illustrated reference current source 112 is constructed from two MOS devices 124 and 126 that are coupled at their sources and that connect across the power supply 116. The control signal 118 is routed to the gate of the NMOS device 124 to regulate the current through both that device 124 and the PMOS device 126.

In the manner described above, the control signal 118 places a voltage bias across the gate to source junction of the NMOS device 124 and draws a proportional reference current through both the NMOS and PMOS devices, 124 and 126. The reference current through the PMOS device 126 causes a voltage drop occurs across the gate-to-drain junction of the PMOS device 126 that is identical to the voltage drop across the gate-to-drain junction of the NMOS device 124. The current drawn through the devices 124 and 126 is independent of the power supply voltage. This structure therefore, isolates the control voltages 136 connected to the switch 114 from deviations in the power supply voltage level.

In this way, the current source 112 produces two control signals 136a, 136b that couple to the switch circuit 114 and are isolated from the level of the power supply 116. These control signals 136a, 136b connect the gates of the devices 124 and 126 to the gates of two current mirror devices 128 and 130 within the switch circuit 114. The voltages at the gates of the MOS device 128 and 130 are proportional to the reference current drawn through the devices 124 and 126 and, therefore, proportional to the control signal 118 received at the gate of the NMOS device 124.

The switch circuit 114 depicted in Fig. 5, is a CMOS inverter circuit constructed as described above. The switch circuit 114 is constructed from an odd number of structurally identical inverting delay stages. The switch circuit 114 illustrated in Fig. 5 is constructed from one inverting delay stage in order to simplify the description of the switching circuit 114. From the following description, it will be appreciated that a plurality of circuits structurally identical to the circuit 114 can be cascaded to create longer delays.

The switch circuit 114 includes two pairs of MOS devices. The first pair, the PMOS device 128 and the NMOS device 130, act as current mirrors that drive current through the second pair of MOS devices, 132 and 134. The second pair of MOS devices 132 and 134 is configured as a switch and controls which current mirror, either 128 or 130, drives the output 122.

The configuration of switch 114 has a switching time delay determined by the time required for the current driven by the active mirror, either 128 or 130, to switch the input capacitance of the following stage or of the attached load, across the stages switching threshold. For the inverter circuit in switch 114, configured from a complementary pair of MOS devices, the threshold voltage is set to one-half the power supply voltage. For this configuration, as the power supply voltage increases, the delay also increases. The result is an oscillator 110, that generates a frequency that is inversely proportional to the power supply voltage.

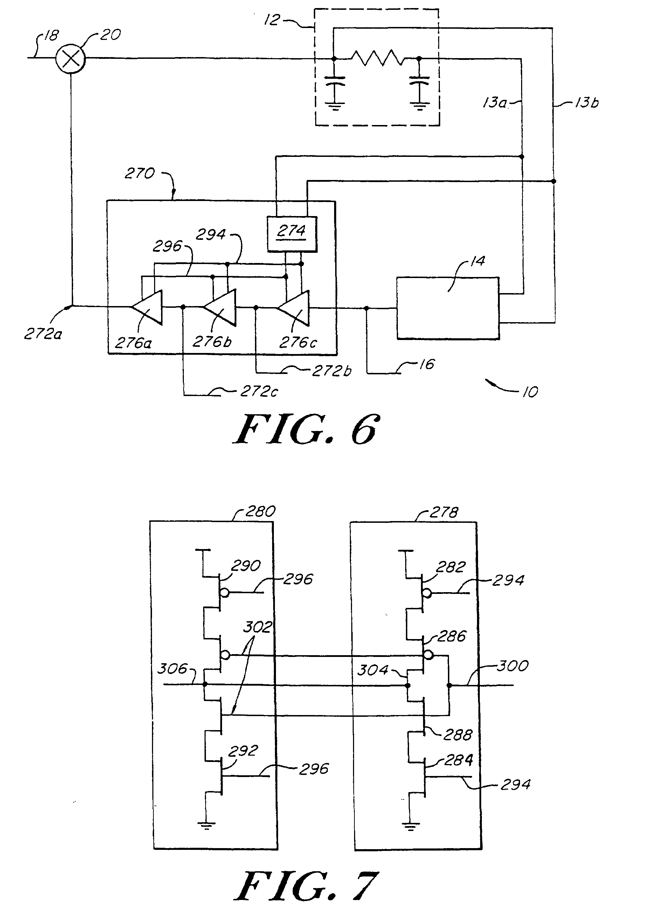

Referring now to Figure 6, there is shown a preferred timing control apparatus for generating a plurality of time-delayed signals coordinated to an input signal. The apparatus includes a delay element 270 for generating the time-delayed signals, designated 272a, 272b, 272c, and a comparator 20 for generating an error signal that represents a difference in phase and frequency between the input signal and at least one of the time-delayed signals, 272a. A filter 12, coupled to the comparator 20, generates plural control signals 13a, 13b each having a voltage amplitude that is a selected function of the error signal. An oscillator 14 receives the control signals 13a, 13b and generates an internal reference clock signal 16 having a frequency and phase that is a function of these control signals. Comparator 20, filter 12 and oscillator 14 preferably operate in accord with the like-designated elements described above.

The internal reference clock signal 16 is fedback to the delay element 270, as indicated, which generates the time-delayed signals 272a, 272b, 272c, each with a frequency substantially equal to that of the clock signal 16, but with a selected time-delay with respect thereto. For this purpose, element 270 can employ plurality of CMOS inverter gates, each driving a respective one of the time-delayed signals, as described below.

It will be appreciated that the position of the delay device 270 within the feed-back loop of the device 10 inserts a selected time delay, and therefore a corresponding phase delay, into the internal clock signal 16. The phase comparator 20 therefore compares a delayed version of the internal reference clock signal 16 to the external reference clock signal 18. As a result, the internal reference clock signal 16 leads the external reference clock signal 18 by the phase delay inserted by the delay device 270. This enables the timing control device 10 to advance the internal timing of a sequential logic device by the selected phase lead, and, consequently, to compensate for known constant time delays within the logic device.

The delay device 270 includes a plurality of delay circuits 276a, 276b, 276c wired in series between the oscillator 14 and the phase comparator 20, and an interface 274. The interface 274 is configured as shown to respond to control signals 13a, 13b to generate delay select signals 294, 296 which are driven to delay circuits 276a, 276b, 276c, as shown. Interface 274 is a voltage controlled current source, preferably, like that described above in connection with element 28 (of Figure 2).

Figure 7 illustrates in detail a preferred embodiment of the delay circuit. There, the circuit is shown to include two stages 278 and 280 wired in parallel. The first stage 278 connects to the second stage 280 so that the input 300 (of stage 278) connects to the input 302 (of stage 280), and so that the output 304 (of stage 278) connects to the output 306 (of stage 280). The two stages 278 and 280 are connected to separate delay select signals and, therefore, are independently controlled.

Stage 278 has two MOS device 282 and 284 that connect to the delay select signals 294. The MOS devices 282 and 284 are configured as current mirrors responsive to the control signals 294 generated by the interface 274. The current mirrors 282 and 284 drive a current through the stage 278 responsive to a selected one of the control signals 13.

The current mirrors 282 and 284 connect to a second pair of MOS devices 286 and 288 that are configured as a CMOS inverter gate. The CMOS inverter gate connects to the input 300 and receives the clock signal propagating through the delay device 270. The CMOS inverter is configured to switch on a current mirror responsive to the signal level applied at the input 300. In response to a high signal on the input 300, the NMOS device 288 is activated and the current source 284 drives the output 304.

The load on the current mirror 284 is fixed. With this structure, and the fixed output load, the output voltage at 304 switches at a speed that is dependent on the current driven by the current mirror 284. Therefore, the delay through the stage 278 is adjusted according to the delay select signal 294.

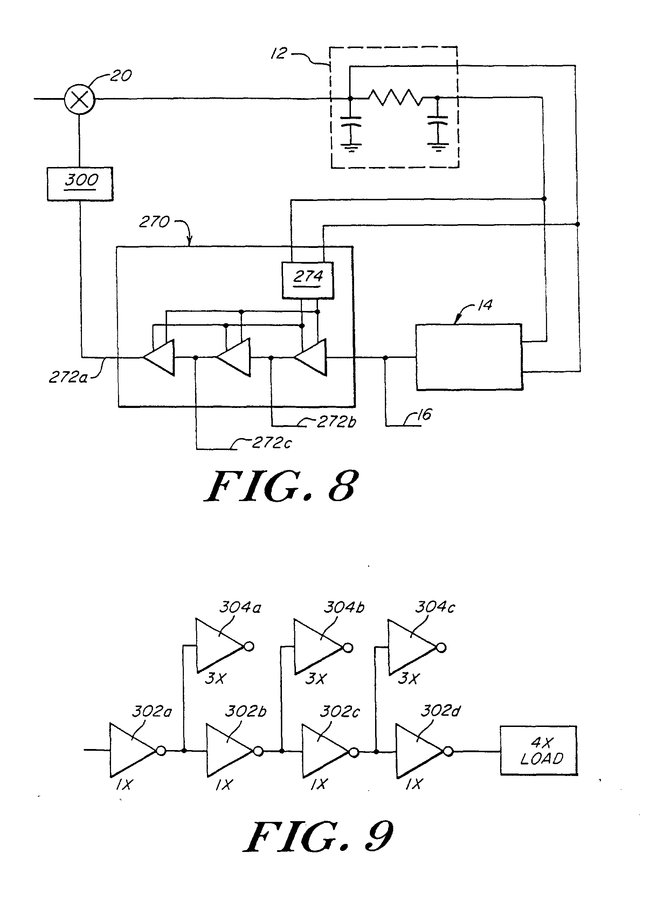

Figure 8 illustrates a preferred embodiment of the invention that further includes a device dependent delay 300, coupled between the oscillator 14 and the comparator 20, to effect delay in the generation of internal clock signal 16 based on the propagation delay of an output buffer of the associated logical device.

Preferably, delay 300 includes a buffer circuit of identical construction to that utilized to drive the output data signals from the logic device. As a result, element 300 suitably delays the internal reference clock 16 before comparison to the external reference clock 18. Accordingly, the oscillator 14 generates a clock signal 16 that leads the external clock signal 18 by a period of time equal to the propagation delay of the output buffer circuits. It will be appreciated that this compensates for the propagation delay of data signals through output buffer circuits and eliminates the signal skew between the individual portions of data output by multiple devices.

Figure 9 illustrates in greater detail the construction of one embodiment of a process dependent delay 300. The purpose of the element 300 is to match any delay introduced when signals are routed between circuit elements, to wit, IC chips. Those skilled in the art will appreciate that the inter-chip delay has two components:

1) Buffering delay. The relatively weak devices inside a chip are generally not able to drive large external loads directly. Producing a signal with sufficient strength typically requires 2 - 4 stages of buffering. The delay introduced by each stage is proportional to the ratio between the sizes of the stage and the load it is driving. This ratio is referred to as the "fanout." For a given process, any two buffers that have the same fanout will produce the same delay.

2) Process delay. Due to variations in the manufacturing process, the chip-to-chip difference in delay for a given fanout can a large amount, typically 200 - 300%.

Those skilled in the art will further appreciate that an addition difficulty makes it difficult to produce a usable on-chip delay which matches the output buffer delay. The difficulty is that on-chip loads are so small that driving them with a 64X buffer produces fanout and process delay well below that "seen" by the last stage of the output buffer.

Figure 9 depicts a preferred delay element 300 capable of compensating for the aforementioned delays and difficulties. The element 300 includes a plurality of equally-sized 1X buffers 302a - 302d connected in series, as shown. An additional "sacrificial" 3X load is added to the output of each 1X buffer. Thus, load 304a is added to the output of buffer 302a, load 304b to buffer 302c, and load 304c to buffer 302d, as shown. This structure produces a fanout of 4X at each stage without requiring an additional load at each stage.

Various aspects of the subject-matter described herein are set out in the following numbered clauses:

1. A timing control apparatus for generating an output signal (16) that is coordinated to an input signal (18), comprising

A. oscillator means (14) for generating said output signal (16),

B. comparator means (20) for receiving said input signal (18) and said output signal (16) and generating an error signal (20c) representative of a difference in phase and frequency between said input (18) and output signals (16), and

C. filter means (12), coupled to said comparator means (20), for receiving said error signal (20c) and generating a plurality of unique control signals (13a,13b) wherein each control signal (13a,13b) has a voltage amplitude with a selected mathematical relationship to said difference between said input (18) and output signal (16),

D. wherein said oscillator means (14) is coupled to said filter means (12) and to said comparator means (20), for receiving said plurality of control signals (13a,13b) and generating said output signal (16) to have a frequency and phase that is a function of the voltage amplitude of said plural control signals (13a,13b), and transmitting said output signal (16) to said comparator means (20).

2. A timing control apparatus according to clause 1 wherein said oscillator means (14) further comprises a summing means (32) for generating said output signal (16) to have a frequency and phase that is a function of a weighted sum of said plurality of control signals (13a,13b).

3. A timing control apparatus according to clause 2 wherein said summing means (32) generates said output signal (16) that has a frequency and phase that is substantially a function of a mathematical relationship

$$4*C1 + 7*C2$$

where C1 is a first one (13b) of said plural control signals (13a,13b) and C2 is a second one (13a) of said plural control signals (13a,13b).

4. A timing control apparatus according to clause 1 wherein said filter means (12) comprises a plurality of subfilter means (22,24,26), each responsive to said error signal (20c), for generating a respective one of said unique control signals (13a,13b) according to a selected transfer characteristic.

5. A timing control apparatus according to clause 4 wherein said subfilter means (22,24,26) comprises means for generating at least one of said control signals (13a,13b) based on a characteristic of a selected frequency spectrum of said error signal.

6. A timing control apparatus according to any one of clauses 1, 4 or 5 wherein said filter means (12) comprises a third order low-pass filter (22, 24, 26) having at least two outputs, each of which generates a respective one of said control signals (13a, 13b) as a function of the frequency of said error signal.

7. A timing control apparatus according to clause 6 wherein said third order low-pass filter (22,24,26) comprises means for generating at least one control signal as a function of a first portion of the frequency spectrum of said error signal, and at least one other control signal as a function of a second portion of the frequency spectrum of said error signal.

8. A timing control apparatus for generating a clock signal (120), comprising

    A. power supply means (116) for providing a power supply voltage level,

    B. current source means (112) coupled to said power supply (116) for generating a reference current that is substantially independent of said power supply voltage, and

    C. switch means (114) coupled to said power supply (116) and to said current source (112) for generating said clock signal (120) to have a time period that is a function of a ratio of said power supply voltage level to-said reference current.

9. A timing control apparatus according to clause 8 wherein said current source means (112) further comprises

    A. input means for receiving an input control signal (118), and

    B. voltage control means (124,126) coupled to said input means for controlling said reference current as a function of the voltage amplitude of said input control signal (118).

10. A timing control apparatus according to clause 8 or 9 wherein said switch means (114) comprises means for decreasing said clock signal time period as a function of an increase in said power supply voltage level.

11. A timing control apparatus according to clause 8 or 9 wherein said switch means (114) comprises means for increasing said clock signal time period as a function of a decrease in said power supply voltage level.

12. A timing control apparatus according to any one of clauses 8 to 11 wherein said switch means is a ring oscillator comprised of an odd number of CMOS inverter circuits (114) connected in series.

13. A timing control apparatus for generating a plurality of time-delayed signals (272a,272b,272c) that are coordinated to an input signal (18), comprising

    A. delay means (270) for generating said plurality of time-delayed signals (272a,272b, 272c),
    B. comparator means (20), coupled to said delay means (270), responsive to said input signal (18) and to one of said time-delayed signals (272a) for generating an error signal representative of a difference in phase and frequency therebetween,
    C. filter means (12) coupled to said comparator means (20), for receiving said error signal and generating a plurality of unique control signals (13a,13b), wherein each control signal (13a, 13b) has a voltage amplitude with a selected mathematical relationship to said difference in phase and frequency.

D. oscillator means (14) coupled to said filter means (12) for responding to said plurality of control signals (13a,13b) for generating an output signal (16) to have a frequency and phase that is a function of said plural control signals (13a,13b), and,

E. wherein said delay means (270) couples to said oscillator means (14), for receiving said output signal (16) and generating said plurality of time-delayed signals (272a,272b,272c) having a frequency substantially equal to that of said output signal (16) and having a selected time-delay with respect thereto.

14. A timing control apparatus for coordinating the delay of information signals output from an electronic circuit in response to an input clock signal, comprising

A. delay means for generating a time-delayed signal,

B. comparator means (20), coupled to said delay means, responsive to said input clock signal (18) and to said time-delayed signal for generating an error signal (20c) representative of a difference in phase and frequency therebetween,

C. filter means (12) coupled to said comparator means, for receiving said error signal and generating a control signal, wherein said control signal has a voltage amplitude with a selected mathematical relationship to said difference in phase and frequency,

D. oscillator means (14) coupled to said filter means (20) for responding to said control signal and generating an output signal having a frequency and phase that is a function of said control signal,

E. circuit means (270) coupled to said oscillator means (14) for generating said information signals, said circuit means including

i) generation means for receiving said output signal to generate said information signals coordinated to said output signal, and

ii) buffer means for outputting said information signals from said circuit means, said buffer means having a characteristic delay, and

iii) wherein said delay means couples to said oscillator means to receive said output signal for generating said time-delayed signal to have a frequency substantially equal to that of said output signal and to have a time delay related to the characteristic delay of said buffer means.

15. A timing control apparatus for time-delaying a clock signal, comprising

A. clock input means for receiving said clock signal,

B. current source means (274) for generating a reference current, and

C. delay means (270) coupled to said current source means (274) and coupled to said clock input means for delaying said clock signal (16) as a function of said reference current.

16. A timing control apparatus according to clause 15 wherein said current reference further comprises

A. control input means for receiving an input control signal (13a,13b), and

B. voltage control means (28) coupled to said control input means for controlling said reference current as a function of the voltage amplitude of said input control signal (13a,13b).

17. A timing and control apparatus according to clause 16 wherein said delay means (270) comprises an inverter circuit coupled to said clock input means and that has an output coupling to transmit said delayed clock signal (272a,272b,272c).

18. A timing and control apparatus according to clause 15 wherein said delay means comprises a plurality of inverter circuits (276a,276b,276c) connected in series and wherein each inverter circuit has an output coupling to transmit one of said delayed clock signals (272a,272b,272c).

19. A timing control apparatus according to clause 18 wherein said plurality of inverter circuits (276a, 276b,276c) connected in series comprises of at least two different size inverter circuits dimensioned to delay said clock signal (16) by at least two different time durations.

The foregoing features of the invention attain a highly accurate timing control device for synchronizing and coordinating a sequential logic device to an external reference clock, and for synchronizing and coordinating the operation of multiple logic devices to an external reference clock signal, so that the timing variations inherent in synchronous computer systems are compensated for within an automatic, closed-loop control system.

Further, the device and method of the invention as described in the foregoing summary can be manufactured as a silicon component carried on the wafer of the logic device. This is desirable to reduce the size and density of computer systems and to facilitate and reduce the cost of system manufacture and assembly.

It will thus be seen that the invention efficiently obtains the objects set forth above, among those made apparent from the previous description. Since certain changes may be made in carrying out the above process or in the device set forth without departing from the scope of the invention, it is intended that all matter contained in the above description or shown in the accompanying drawings be interpreted as illustrative and not in a limiting sense.

It is also to be understood that the following claims are to cover all generic and specific features of the invention described herein, and all statements of the scope of the invention which, as a matter of language, might be said to fall therebetween.

## Claims

1. A timing control apparatus for generating at least one time-delayed signal coordinated to an input signal, the apparatus comprising:

   an oscillator that generates an internal clock signal;
   a delay element that generates at least one time-delayed signal offset from that internal clock signal;
   a comparator that compares the internal and external clock signals to generate an error signal that indicates the phase and frequency difference therebetween; and
   a filter, coupled to the comparator, that generates at least one control signal having a characteristic that is a selected function of the error signal, wherein each control signal is fed to the oscillator, the output of the oscillator is fed to the delay element, and each time-delayed signal generated by the delay element has a frequency substantially equal to that of the output signal and a selected time-delay with respect thereto.

2. The timing control apparatus of claim 1, wherein the input signal is an external clock signal.

3. The timing control apparatus of claim 1 or claim 2, wherein said characteristic of the control signals is a voltage amplitude.

4. The timing control apparatus of any of claims 1 to 3, wherein the delay element comprises a ring of CMOS inverter gates.

5. The timing control apparatus of any of claims 1 to 4, wherein said internal clock signal forms an output signal.

6. The timing control apparatus of any of claims 1 to 5, wherein each control signal has a voltage amplitude with a selected mathematical relationship to said difference in phase and frequency.

7. The timing control circuit of any of claims 1 to 6, wherein said internal clock signal has a frequency and phase that is a function of said control signal.

8. The timing control apparatus of any of claims 1 to 7, further comprising circuitry for delaying the generation of output signals transmitted by an output buffer of an associated logical device, the circuitry comprising a device-dependent delay element, coupled to the oscillator, for generating an output-effecting strobe signal that has a frequency substantially equal to the internal clock signal but that is time-delayed in accord with a characteristic delay of the output buffer.

9. The timing control apparatus of any of claims 1 to 8 operable to coordinate the delay of information signals output from an electronic circuit in response to an input clock signal, the timing control apparatus further comprising:

   circuit means coupled to said oscillator means for generating said information signals, said circuit means including

   i) generation means for receiving said internal clock signal to generate said information signals coordinated to said internal clock signal, and
   ii) buffer means for outputting said information signals from said circuit means, said buffer means having a characteristic delay,

   and wherein said delay means generates said time-delayed signal to have a time delay related to the characteristic delay of said buffer means.

*FIG. 1*

*FIG. 2*

# FIG. 3

**FIG. 4**

**FIG. 5**

**FIG. 6**

**FIG. 7**

*FIG. 8*

*FIG. 9*

FIG. 10

## EUROPEAN SEARCH REPORT

European Patent Office

Application Number

EP 01 20 1022

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 4 521 745 A (FALCONER ROBERT M) 4 June 1985 (1985-06-04) | 1-7 | H03K5/13 H03L7/081 |
| A | * column 6, line 47 - column 7, line 20; figures 6-8 * | 8,9 | |
| X | EP 0 297 719 A (HEWLETT PACKARD CO) 4 January 1989 (1989-01-04) | 1-7 | |
| A | * column 3, line 55 - column 5, line 20; figure 2 * | 8,9 | |
| X | GB 2 073 515 A (INT STANDARD ELECTRIC CORP) 14 October 1981 (1981-10-14) * the whole document * | 1 | |
| A | "Phase-Locked Loop with Programmable Phase Offset" IBM TECHNICAL DISCLOSURE BULLETIN , vol. 32, no. 2, July 1989 (1989-07), pages 473-474, XP002169032 Armonk, NY, US * the whole document * | 1-9 | |

TECHNICAL FIELDS SEARCHED (Int.Cl.7)

H03K
H03L
H04L
G06F

The present search report has been drawn up for all claims

| Place of search | Date of completion of the search | Examiner |
|---|---|---|
| THE HAGUE | 7 June 2001 | Jepsen, J |

## ANNEX TO THE EUROPEAN SEARCH REPORT
## ON EUROPEAN PATENT APPLICATION NO.

EP 01 20 1022

This annex lists the patent family members relating to the patent documents cited in the above-mentioned European search report.
The members are as contained in the European Patent Office EDP file on
The European Patent Office is in no way liable for these particulars which are merely given for the purpose of information.

07-06-2001

| Patent document cited in search report | | Publication date | Patent family member(s) | | Publication date |
|---|---|---|---|---|---|
| US 4521745 | A | 04-06-1985 | AT | 16439 T | 15-11-1985 |
| | | | AT | 38303 T | 15-11-1988 |
| | | | AU | 565107 B | 03-09-1987 |
| | | | AU | 5007085 A | 27-03-1986 |
| | | | AU | 549343 B | 23-01-1986 |
| | | | AU | 8437382 A | 16-12-1982 |
| | | | CA | 1182874 A | 19-02-1985 |
| | | | DE | 3267259 D | 12-12-1985 |
| | | | DE | 3279168 D | 01-12-1988 |
| | | | EP | 0067053 A | 15-12-1982 |
| | | | EP | 0139126 A | 02-05-1985 |
| | | | HK | 50788 A | 15-07-1988 |
| | | | IN | 157651 A | 10-05-1986 |
| | | | JP | 58079340 A | 13-05-1983 |
| | | | NZ | 200869 A | 30-08-1985 |
| | | | NZ | 210217 A | 30-08-1985 |
| | | | ZA | 8203867 A | 27-07-1983 |
| EP 0297719 | A | 04-01-1989 | US | 4813005 A | 14-03-1989 |
| | | | DE | 3853450 D | 04-05-1995 |
| | | | DE | 3853450 T | 27-07-1995 |
| | | | JP | 1019827 A | 23-01-1989 |
| | | | JP | 2749325 B | 13-05-1998 |
| | | | KR | 9109087 B | 28-10-1991 |
| GB 2073515 | A | 14-10-1981 | FR | 2480048 A | 09-10-1981 |
| | | | BE | 888265 A | 05-10-1981 |

EPO FORM P0459

For more details about this annex : see Official Journal of the European Patent Office, No. 12/82